# EUROPÄISCHE PATENTSCHRIFT

(11) **EP 3 425 756 B1**
(45) Veröffentlichungstag und Bekanntmachung des Hinweises auf die Patenterteilung: **25.03.2020**
(21) Anmeldenummer: 17001162.1
(22) Anmeldetag: 07.07.2017
(51) Int. Cl.: H01T 4/04, H05K 7/14

(54) **GEHÄUSE ZUR AUFNAHME EINER PLATINE MIT EINER ÜBERSPANNUNGSSCHUTZEINHEIT SOWIE ÜBERSPANNUNGSSCHUTZMODUL**
HOUSING FOR RECEIVING A PRINTED CIRCUIT BOARD HAVING AN OVERVOLTAGE PROTECTION UNIT AND OVERVOLTAGE PROTECTION MODULE
BOÎTIER DE RÉCEPTION D'UNE PLATINE COMPRENANT UNE UNITÉ DE PROTECTION CONTRE LES SURTENSIONS ET MODULE DE PROTECTION CONTRE LES SURTENSIONS

(43) Veröffentlichungstag der Anmeldung: 09.01.2019
(73) Patentinhaber: Pepperl+Fuchs AG, 68307 Mannheim (DE)
(72) Erfinder: Lebkücher, Thomas, 67071 Ludwigshafen (DE)
(74) Vertreter: Koch Müller Patentanwaltsgesellschaft mbH

(56) Entgegenhaltungen:
- WO-A1-2014/173458
- US-A1- 2002 129 954

## Beschreibung

Die Erfindung betrifft ein Gehäuse zur Aufnahme einer Platine mit einer Überspannungsschutzeinheit sowie ein Überspannungsschutzmodul.

Aus der WO 2014/173458 A1 ist ein Aufnahmesockel zum Aufnehmen und Kontaktieren eines elektronischen Moduls bekannt, wobei der Aufnahmesockel über entsprechende Anschlüsse in einen Schaltkreis integriert ist und das elektronische Modul mittels zweier Kontaktzungen auf einfache Weise auf das Modul aufsteckt und elektrisch angeschlossen wird.

Aus der US 2002 / 129 954 A1 ist eine Überspannungsschutzeinheit mit einem Gehäuse zur Aufnahme einer Platine bekannt, wobei zwei Hauptschenkel und zwei Seitenschenkel und eine seitlich verlaufende flache Verstrebung offenbart ist.

Elektronische Module sowie die Anschlüsse an einen Schaltkreis, z.B. mittels einer Hutschiene, sind hinsichtlich ihrer äußeren Abmessungen typischerweise genormt und müssen im Allgemeinen möglichst fugenfrei anreihbar sein.

Das Überspannungsschutzgerät TT-EX(I)-M-24DC - 2803865 der Firma PHOENIX CONTACT Deutschland GmbH ist beispielsweise eine Reihenklemme mit einer genormten Höhe von ca. 6,1 bis 6,2 mm. Die Gehäusewand an der Seite weist eine Dicke von ca. 0,75 mm auf. Da die verwendeten Gasentladungsröhren bereits einen Durchmesser von ca. 5 mm aufweisen, weist die Platine des Überspannungsschutzgeräts im Bereich der Gasentladungsröhren eine Ausnehmung auf. Ferner weist eine Seitenwandtragstruktur des Gehäuses oberhalb der Gasentladungsröhren eine Öffnung auf, d.h. das Gehäuse ist an der Seitenwand offen. Beide Maßnahmen dienen dazu, die Höhe einhalten zu können.

Vor diesem Hintergrund besteht die Aufgabe der Erfindung darin, eine Vorrichtung anzugeben, die den Stand der Technik weiterbildet.

Die Aufgabe wird durch ein Gehäuse mit den Merkmalen des Patentanspruchs 1 sowie durch ein Überspannungsschutzmodul gemäß Anspruch 14 gelöst. Vorteilhafte Ausgestaltungen der Erfindung sind Gegenstand von Unteransprüchen.

Gemäß einem Gegenstand der Erfindung weist ein Gehäuse zur Aufnahme einer Platine mit einer Überspannungsschutzeinheit einen Tragrahmen und eine Folie auf, wobei der Tragrahmen zumindest teilweise aus einem thermoplastischen Kunststoff besteht und einen Hauptschenkel, zwei sich an jeweils einem Ende an den Hauptschenkel anschließende Seitenschenkel und mindestens eine zwischen den beiden Seitenschenkeln verlaufende seitliche, flache Verstrebung aufweist.

Die Folie besteht zumindest teilweise aus einem thermoplastischen Kunststoff und ist u-förmig mit einer Stirnseite und zwei Seitenflächen ausgebildet, wobei die Stirnseite der Folie eine Stirnseite des Hauptschenkels zumindest teilweise überdeckt, jede Seitenfläche der Folie die beiden Seitenschenkel und die Verstrebung jeweils zumindest teilweise überdeckt und die Folie mit den Seitenschenkeln stoffschlüssig verbunden ist, so dass das Gehäuse aus Tragrahmen und Folie an einer der Stirnseite der Folie gegenüberliegenden Seite zumindest teilweise offen ist.

Als Folie wird ein flächiger Kunststoffkörper mit einem geringen Dicke bzw. Wandstärke und einem vorzugsweise geringen Flächenträgheitsmoment bezeichnet.

Eine U-förmige Folie ist durch aufschieben besonders einfach auf bzw. um den Tragrahmen positionierbar, so dass das Gehäuse besonders einfach herstellbar ist.

Die Folie ist mit dem Tragrahmen kraftschlüssig und/oder stoffschlüssig verbunden, bevorzugt durch Schweißen oder durch Heißverstemmen, so dass die Folie und der Tragrahmen zusammen ein Gehäuse des Überspannungsschutzmoduls ausbilden. Der Tragrahmen weist hierfür bevorzugt Schweißgebiete, besonders bevorzugt im Bereich der beiden seitlichen Schenkel auf.

Es sei angemerkt, dass der Tragrahmen eine flache, nur teilweise umrandete Aufnahme für eine Platine darstellt, wobei zumindest eine dem Hauptschenkel gegenüberliegende Tragstruktur fehlt und ein Überstehen einer eingelegten Platine über die erste Seitenwandtragstruktur ermöglicht. Die Stabilität des Tragrahmens wird durch die seitliche Verstrebung erhöht, ohne einen Innenraum des Gehäuses zu sehr einzuschränken bzw. zu verkleinern.

Es versteht sich, dass die Folie zumindest einen Teil einer Stirnseite des Gehäuses und von zwei Seitenflächen des Gehäuses ausbildet und dass die seitlichen Schenkel zumindest eine Oberseite und eine Unterseite des Gehäuses ausbilden.

Des Weiteren sei angemerkt, dass das Gehäuse eine plane Seitenwand aufweist und dadurch mehrere Gehäuse nahezu oder vollständig fugenlos anreihbar sind.

Ein Vorteil ist, dass sich mittels der Folie die Dicke der Seitenwand derart verringern lässt, dass das Gehäuse auch an der Seite vollständig geschlossen ist. Anders ausgedrückt, die Platine ist vor Umwelteinflüssen geschützt. Des Weiteren sind spannungsführende Bauelemente nunmehr gegen Berührung geschützt. Die Zuverlässigkeit wird dadurch erhöht.

Ein anderer Vorteil besteht darin, dass das Verhältnis von Dicke der Gehäuseteile zu Bauteildurchmesser oder Dicke sich gegenüber dem Stand der Technik verbessert. Auch bei einer geringen Breite lassen sich relativ Dicke oder einen großen Durchmesser aufweisende Bauteile in dem Gehäuse mit einer geringen Baubreite zusammenfügen.

Nur in dem Bereich der Verstrebung wird die Platine zumindest entlang der Oberseite oder der Unterseite auch von einem Teil des Tragrahmens umgeben, ansonsten werden eine Platinenoberseite sowie eine Platinenunterseite nur von der Folie umschlossen. Hierdurch beträgt die lichte Höhe des Gehäuses in dem Bereich ohne Verstrebung die gegebenenfalls von einer Norm vorgeschriebene Gehäusebreite abzüglich der Dicke der Folie und wird nicht durch die Dicke von Tragrahmenwänden begrenzt.

Gemäß alternativer Ausführungsformen ist die Verstrebung als Fläche mit mindestens einer Durchgangsöffnung oder als Steg ausgebildet. So wird zumindest im Bereich der Durchgangsöffnungen bzw. in Bereichen vor oder hinter dem Steg eine maximale Lichte Breite in dem Gehäuseinneren erreicht.

In einer Ausführungsform besteht der Tragrahmen aus einem anderen Material als die Folie.

Gemäß einer Weiterbildung weist der Tragrahmen in einer Verlängerung des Hauptschenkels eine sich an den zweiten seitlichen Schenkel oder an den ersten seitlichen Schenkel anschließenden Zusatzaufnahme für ein mindestens vier Kontakte aufweisendes Digtalanschlussteil auf.

Als Zusatzaufnahme wird vorliegend ein Teil des Tragrahmens bezeichnet, der sich an den die Platine aufnehmenden Tragrahmenteil anschließt und Platz für ein Digitalanschlussteil bietet.

In einer anderen Weiterbildung weist der Tragrahmen an mindestens einem der beiden seitlichen Schenkel ein mechanisches Verriegelungsmittel, z.B. ein bewegbarer Stift oder Haken, auf, wobei das mechanische Verriegelungsmittel parallel zu einer Flächennormalen der Stirnseite des Hauptschenkels wirkt.

Das Verriegelungsmittel wirkt in eine Richtung entgegen der Steckrichtung, beispielsweise mittels eines Stifts oder eines hackförmigen Formteils und verhindert durch einen Formschluss ein Lösen der Steckverbindung.

In einer anderen Ausführungsform weisen die beiden seitlichen Schenkel jeweils eine Stirnseite, eine an die Stirnseite angrenzende erste Seitenfläche und eine an die Stirnseite angrenzende und der ersten Seitenfläche gegenüberliegende zweite Seitenfläche auf und insbesondere weisen die Stirnseiten der seitlichen Schenkel von der ersten Seitenfläche zu der zweiten Seitenfläche jeweils eine Breite auf, wobei die Breite kleiner oder gleich einer maximalen Breite der Stirnseite des Hauptschenkels ist.

Gemäß einer weiteren Ausführungsform ist ein Abstand zwischen der ersten Seitenfläche der beiden seitlichen Schenkel zu der zweiten Seitenfläche in einem von der Folie überdeckten Bereich konstant oder ändert sich stetig.

Gemäß einer Weiterbildung weist der Hauptschenkel des Tragrahmens zumindest einen ersten Bereich mit einer maximalen Breite in eine parallel zu einer Flächennormalen der Verstrebung verlaufenden Richtung gemessen auf, wobei die maximale Breite kleiner 7 mm oder in einem Bereich zwischen 6,3 mm und 6,1 mm oder genau 6,2 mm oder kleiner als 6,2 mm ist.

In einer weiteren Weiterbildung weist die Stirnseite des Hauptschenkels mindestens einen von zwei Stufen begrenzten zweiten Bereich mit einer zweiten Breite aufweist, wobei die zweite Breite kleiner als die erste Breite ist.

Bevorzugt weist die Stirnseite des Hauptschenkels zumindest in einem von der Folie überdeckten Bereich eine konstante oder im Wesentlichen konstante Breite auf.

In einer anderen Weiterbildung weist die Stirnseite des Hauptschenkels mindestens eine Durchgangsöffnung oder mindestens eine Aussparung auf. Als Aussparung wird eine ab eine Stirnseitenkante reichende durchgehende Öffnung, ähnlich einer Kerbe bezeichnet. Mittels der Durchgangsöffnung oder Aussparung kann das Signal eines auf der Oberseite der Platine vor der mindestens einen Durchgangsöffnung positionierten optischen Signalgebers, z.B. eine LED, nach Außen gelangen.

Bevorzugt überdeckt die Folie die mindestens eine Durchgangsöffnung oder die mindestens eine Aussparung der Stirnseite des Hauptschenkels mit einem ersten Folienabschnitt, wobei der erste Folienabschnitt transparent ist.

Gemäß einer weiteren Ausführungsform weist der erste seitliche Schenkel und/oder der zweite seitliche Schenkel mindestens eine Justiernase auf und die Folie weist ein der Justiernase entsprechende Durchgangsloch auf. Bevorzugt ist die mindestens eine Justiernase auf mindestens einer Seitenfläche, insbesondere näher an einem von dem Hauptschenkel entfernten Ende angeordnet.

In einer anderen Ausführungsform weist eine der erste und/oder der zweite seitliche Schenkel eine mit der Folie abschließende Fase auf. Bevorzugt ist die Fase auf einer Seitenfläche der seitlichen Schenkel angeordnet und beginnt besonders bevorzugt an einem an den Hauptschenkel angrenzenden Ende.

Die Fase stellt eine einfach herzustellende Justierhilfe für das Positionieren der Folie auf bzw. um den Tragrahmen dar, die bevorzugt sowohl in hinsichtlich der Breite als auch hinsichtlich der lateralen Position mit der Folie abschließt.

In einer anderen Ausführungsform weist die Stirnseite der Folie von der ersten Seitenfläche zu der zweiten Seitenfläche eine Stirnseitenbreite auf, wobei die Stirnseitenbreite die Breite der Stirnseite des Hauptschenkels in einem von der Folie überdeckten Bereich um höchstens 10% übersteigt.

Gemäß einer bevorzugten Weiterbildung ist die Folie bedruckt, wodurch das Herstellungsverfahren des Überspannungsschutzmoduls sich insgesamt vereinfachen lässt. Ein Vorteil ist, dass sich der Aufdruck auf der Folie leicht und schnell ändern lässt.

In einer Ausführungsform weist Folie eine Dicke kleiner als 0,35 mm oder kleiner als 0,25 mm auf, wobei die Dicke der Folie größer als 0,05 mm ist.

Der Hauptschenkel, die seitlichen Schenkel und die Verstrebung weisen bevorzugt eine Dicke von mindestens 0,25 oder mindestens 0,30 mm auf. Vorzugsweise weisen Schenkel und Verstrebung eine Dicke kleiner als 2,0 mm auf.

Gemäß einer bevorzugten Ausführungsform weisen der erste seitliche Schenkel und / oder der zweite seitliche Schenkel eine Länge auf, wobei die maximale Breite der Stirnseite des Hauptschenkels zu der Länge der seitlichen Schenkel ein Verhältnis von mindestens 1:5 oder mindestens 1:10 aufweist.

Bevorzugt weist die maximale Breite der Stirnseite des Hauptschenkels zu einer Länge des Hauptschenkels ein Verhältnis von mindestens 1:5 oder mindestens 1:10 aufweist.
In einer Weiterbildung umfasst die Überspannungsschutzeinheit eine Gasentladungsröhre.

Gemäß einem weiteren Gegenstand der Erfindung weist ein Überspannungsschutzmodul eine Platine mit einer Überspannungsschutzeinheit und einem Gehäuse der vorbeschriebenen Art auf, wobei die Platine bevorzugt eine Kontaktzunge mit mindestens einer Kontaktfläche aufweist und die Kontaktzunge der Platine über die Verstrebung des Tragrahmens oder über den ersten seitlichen Schenkel und/oder den zweiten seitlichen Schenkel hinausragt. Besonders bevorzugt umfasst die Überspannungsschutzeinheit eine Gasentladungsröhre.

Es versteht sich, dass auch die Folie die Kontaktzunge nicht überdeckt, um weder das Stecken noch das elektrische kontaktieren zu behindern. Ein elektrischer Kontakt zwischen einem Schaltkreis der Platine und einem externen Schaltkreis wird mittels der Kontaktfläche auf der Kontaktzunge und entsprechender Gegenstücke des weiteren Bauteils hergestellt.

Auch sei angemerkt, dass das Überspannungsschutzmodul mittels der mindestens einen über die erste Seitenwandtragstruktur hinausragende Kontaktzunge der Platine durch Einstecken mit einem weiteren Bauteil, beispielsweise einem Aufnahmesockel verbunden wird.

Ein Vorteil der erfindungsgemäßen Vorrichtung ist, dass das Überspannungsschutzmodul ein vollständig geschlossenes Gehäuse aufweist, welches einfach und kostengünstig herstellbar ist.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die:
- Figur 1 A, B: eine schematische Ansicht auf eine erste erfindungsgemäße Ausführungsform eines Überspannungsschutzmoduls,
- Figur 2 A, B: eine schematische Ansicht auf eine erste erfindungsgemäße Ausführungsform eines Tragrahmens des Überspannungsschutzmoduls,
- Figur 3: eine schematische Ansicht auf eine erste erfindungsgemäße Ausführungsform einer Folie des Überspannungsschutzmoduls,
- Figur 4: eine schematische Ansicht auf eine erste erfindungsgemäße Ausführungsform einer Platine des Überspannungsschutzmoduls.

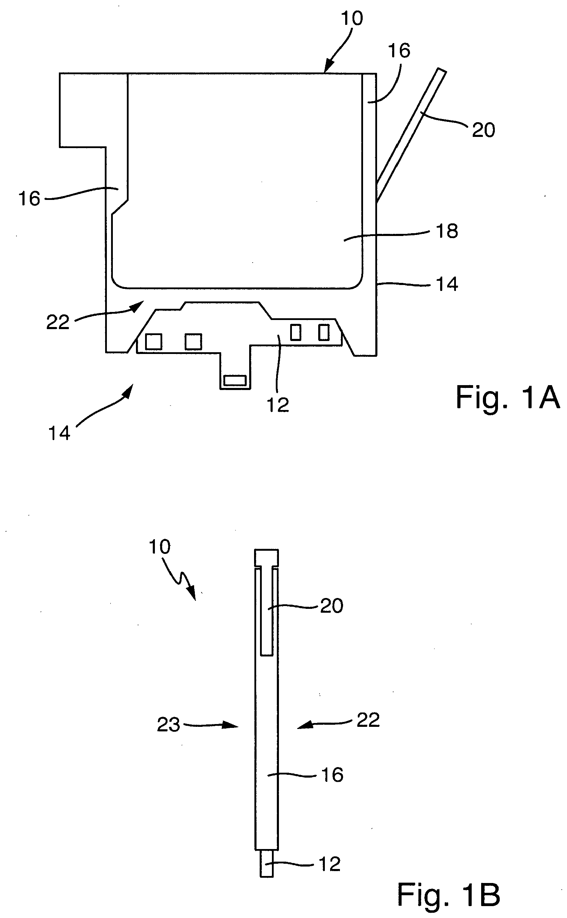

Die Abbildungen der Figuren 1A und 1B zeigen eine Aufsicht bzw. eine seitliche Ansicht auf eine erste Ausführungsform eines Überspannungsschutzmoduls 14, aufweisend eine Platine 12 und ein Gehäuse 10, wobei das Gehäuse 10 aus einem Tragrahmen 16 und einer Folie 18 gebildet ist und ein mechanisches Verriegelungsmittel 20 aufweist.

Die Folie 18 liegt auf einer seitlichen, flachen Verstrebung 22 des Tragrahmens 16 auf.

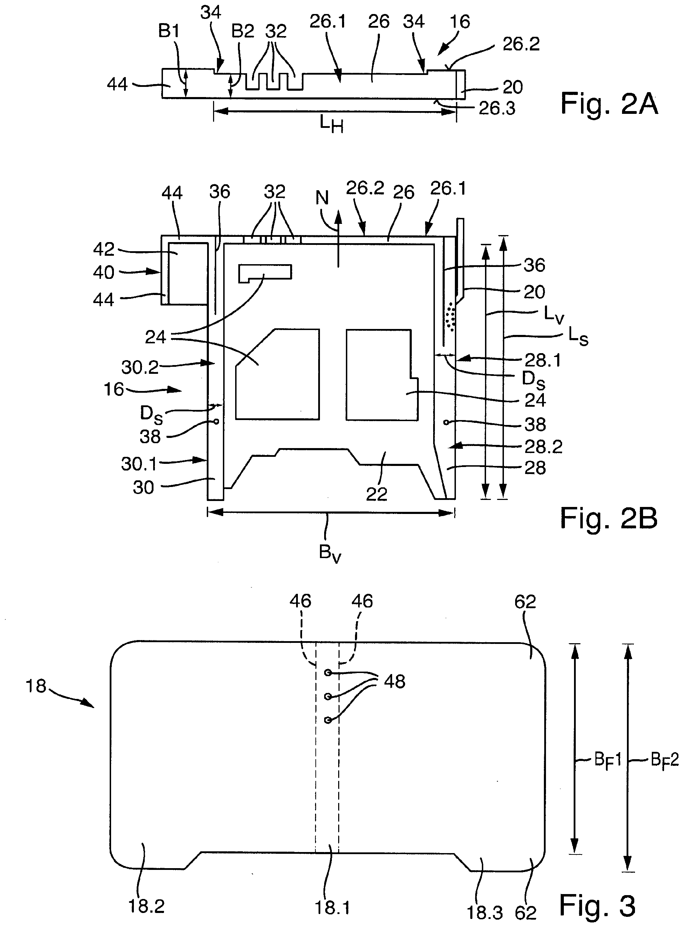

In den Abbildungen der Figur 2A und 2B ist der Tragrahmen 16 des Überspannungsschutzmoduls 10 aus Figur 1 in einer seitlichen Ansicht sowie in einer Aufsicht schematisch dargestellt.

Der Tragrahmen 16 weist eine Hauptschenkel 26, zwei seitliche Schenkel 28 und 30, eine Verstrebung 22 und das Verriegelungsmittel 20 auf. Der Hauptschenkel 26 sowie die beiden seitlichen Schenkel 28 und 30 weisen jeweils eine Stirnseite 26.1, 28.1 bzw. 30.1 sowie jeweils eine an die jeweilige Stirnseite 26.1, 28.1 bzw. 30.1 angrenzende erste Seitenfläche 26.2, 28.2 bzw. 30.2 und eine an die Stirnseite angrenzenden und der ersten Seitenfläche 26.2, 28.2 bzw. 30.2 gegenüberliegende zweite Seitenfläche 26.3 auf. Die Stirnseite 26.1 des Hauptschenkels 26 bildet zumindest teilweise eine Stirnseite des Gehäuses 10 aus. Die Stirnseite 28.2 des ersten seitlichen Schenkels 28 bildet eine Unterseite des Gehäuses 10 und die Stirnseite 30.1 des zweiten seitlichen Schenkels 30 eine Oberseite des Gehäuses 10 aus.

Die Verstrebung 22 ist flächig ausgebildet, erstreckt zwischen zwischen den zweiten Seitenflächen der seitlichen Schenkel 28, 30 und bis zu der zweiten Seitenfläche 26.3 des Hauptschenkels 26. Die Verstrebung 22 weist eine Breite B_{V}, eine Länge L_{V} sowie drei Durchgangsöffnungen 24 auf.

Die Stirnseite 26.1 des Hauptschenkels 22 weist drei Aussparungen 32, eine maximale Breite B1 in einem äußeren Bereich, eine zweite, verringerte Breite B2 in einem mittleren Bereich und eine Länge L_{H} auf, wobei die zweite verringerte Breite B2 etwas kleiner als die maximale Breite B1 ist. Idealer Weise entspricht die Differenz zwischen der maximalen Breite B1 und der zweiten, verringerten Breite B2 einer Dicke D_{F} der Folie 18. Durch die Differenz der Breiten B1 und B2 weist die Stirnseite 26.1 des Hauptschenkels 26 entlang einer oberen Kante zwei Stufen 34 auf, wobei ein Abstand zwischen den beiden Stufen 34 in idealer Weise einer Breite B_{F}1 der Folie 18 entspricht.

Die beiden Stufen 34 setzen sich jeweils als Kante bzw. Fase 36 zumindest teilweise entlang der ersten Seitenflächen 28.2 und 30.2 der beiden seitlichen Schenkel 28 und 30 fort und dienen als Führungsschiene bzw. Justierhilfe für die Folie 18. Zusätzlich weisen die ersten Seitenflächen 28.2 und 30.2 der beiden seitlichen Schenkel 28 und 30 jeweils eine Justiernase 38, z.B. einen Stachel, Dorn, auf.

Eine Breite der Stirnseiten 28.1 und 30.1 der beiden seitlichen Schenkel 28, 30 entspricht der ersten Breite B1 der Stirnseite 26.1 des Hauptschenkels 26. Die seitlichen Schenkel 28 und 30 weisen jeweils eine Länge L_{S} und eine Dicke D_{S} auf.

In einer Verlängerung des Hauptschenkels 26 und an die Stirnseite 30.2 des zweiten seitlichen Schenkels 30 angrenzend weist der Tragrahmen 16 eine sich Zusatzaufnahme 40 auf, wobei die Zusatzaufnahme 40 zwei Seitenwände 44 und eine flächige, vollständig geschlossenen Verstrebung 42 zwischen den Seitenwänden 44 und dem zweiten seitlichen Schenkel 30 aufweist.

Die Zusatzaufnahme 40 bzw. deren Seitenwände 44 weisen im dargestellten Ausführungsbeispiel die Breite B1 auf, so dass die Stirnseite 26.1 des Hauptschenkels stufenlos in die Seitenwand 44 der Zusatzaufnahme 40 übergeht.

Das Verriegelungsmittel 20 ist in und an der Stirnseite 28.2 des ersten seitlichen Schenkels 28 angeordnet, wobei ein Haken zum Lösen mittels eines Hebels in dem ersten seitlichen Schenkel 28 versenkt wird und zum Verriegeln in eine über die Stirnseite 28.2 des ersten seitlichen Schenkels hinausstehende Position bewegt wird.

Eine der Verstrebung 22 gegenüberliegende weitere Verstrebung oder Seitenwandstruktur weist der Tragrahmen 16 nicht auf.

Die Figur 3 zeigt die Folie 18 der Überspannungsschutzmoduls 14 aus Figur 1. Die Folie 18 weist in einem mittleren Bereich eine Breite B_{F}1 und in einem äußeren Bereich eine Breite B_{F}2 auf.

Die Folie wird in dem mittleren Bereich entlang der gestrichelten Linien 46 gefalzt, wodurch sich eine u-förmige Gestalt mit einer Stirnseite 18.1 und zwei Seitenflächen 18.2 und 18.3 ergibt. Ein Abstand zwischen den beiden Linien 46 bzw. Falzen entspricht idealer Weise der zweiten Breite B2 der Stirnseite 26.1 des Hauptschenkels 26. Die Breite B_{F}1 entspricht idealer Weise dem Abstand zwischen den beiden Stufen 24 der Stirnseite 26.1 des Hauptschenkels.

In dem Bereich zwischen den beiden Linien 46 bzw. Falzen sind drei Abschnitte 48 angeordnet, wobei die Folie zumindest in den drei Abschnitten 48 transparent ist. Eine Position der Abschnitte 48 entlang der Breite B_{F}1 entspricht einer Position der Ausnehmungen 32 der Stirnseite 26.1 des Hauptschenkels 26 zwischen den Kanten 34.

Ferner weist die Folie zwei Durchgangslöcher 62 auf, deren Querschnitt den am Tragrahmen 16 angeordneten Justiernasen 38 entspricht und deren Position auf die Position der Justiernasen 38 des Tragrahmens 16 abgestimmt sind.

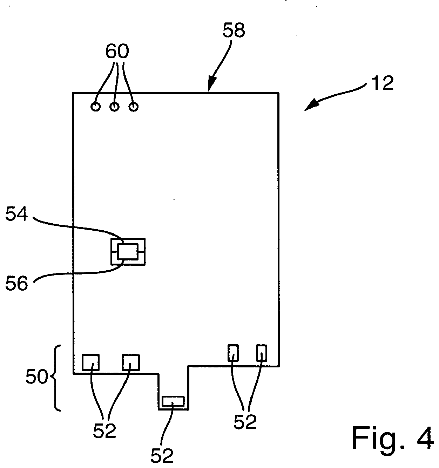

In der Abbildung der Figur 4 ist die Platine 12 des Überspannungsschutzmoduls 14 aus Figur 1 dargestellt. Die Platine 12 umfasst eine Kontaktzunge 50, wobei die Kontaktzunge 50 fünf Kontaktflächen 52 aufweist.

Die Platine 12 weist eine Durchgangsöffnung 54 und eine in der Durchgangsöffnung 54 angeordnete Überspannungsschutzeinheit 56 auf, wobei die Überspannungsschutzeinheit 56 mit Leiterbahnen der Platine 18 verschaltet ist. An einem der Kontaktzunge 50 gegenüberliegenden Rand 58 der Platine 12 sind drei LEDs als optische Signalgeber 60 angeordnet.

## Patentansprüche

1. Gehäuse (10) zur Aufnahme einer Platine (12) mit einer Überspannungsschutzeinheit (56), aufweisend einen Tragrahmen (16), wobei
- der Tragrahmen (16) zumindest teilweise aus einem thermoplastischen Kunststoff besteht und einen Hauptschenkel (26), zwei sich an jeweils einem Ende an den Hauptschenkel (26) anschließende Seitenschenkel (28, 30) und mindestens eine zwischen den beiden Seitenschenkeln (28, 30) verlaufende seitliche, flache Verstrebung (22) aufweist,
**dadurch gekennzeichnet, dass**
eine Folie vorgesehen ist, und
- die Folie (18) zumindest teilweise aus einem thermoplastischen Kunststoff besteht und u-förmig mit einer Stirnseite (18.1) und zwei Seitenflächen (18.2, 18.3) ausgebildet ist,
- die Stirnseite (18.1) der Folie (18) eine Stirnseite (26.1) des Hauptschenkels (26) zumindest teilweise überdeckt,
- jede Seitenfläche (18.2, 18.3) der Folie (18) die beide Seitenschenkel (28, 30) sowie die Verstrebung (22) jeweils zumindest teilweise überdeckt und
- die Folie (18) mit den Seitenschenkeln (28, 30) stoffschlüssig verbunden ist,
- so dass das Gehäuse (10) aus Tragrahmen (16) und Folie (18) an einer der Stirnseite (18.1) der Folie (18) gegenüberliegenden Seite zumindest teilweise offen ist.

2. Gehäuse (10) nach Anspruch 1, **dadurch gekennzeichnet, dass** die Verstrebung (22) als Fläche mit mindestens einer Durchgangsöffnung (24) oder als Steg ausbildet ist.

3. Gehäuse (10) nach Anspruch 1 oder Anspruch 2, **dadurch gekennzeichnet, dass** der Tragrahmen (16) aus einem anderen Material besteht als die Folie (18).

4. Gehäuse (10) nach einem der Ansprüche 1 bis 3, **dadurch gekennzeichnet, dass** der Tragrahmen (16) in einer Verlängerung des Hauptschenkels (26) eine sich an den zweiten seitlichen Schenkel (30) oder an den ersten seitlichen Schenkel (28) anschließenden Zusatzaufnahme (40) für ein mindestens vier Kontakte aufweisendes Digtalanschlussteil aufweist.

5. Gehäuse (10) nach einem der Ansprüche 1 bis 4, **dadurch gekennzeichnet, dass** die beiden seitlichen Schenkel (28, 30) jeweils eine Stirnseite (28.1, 30.1), eine an die Stirnseite (28.1, 30.1) angrenzende erste Seitenfläche (28.2, 30.2) und eine an die Stirnseite (28.1, 30.1) angrenzende und der ersten Seitenfläche (28.2, 30.2) gegenüberliegende zweite Seitenfläche aufweisen.

6. Gehäuse (10) nach Anspruch 5, **dadurch gekennzeichnet, dass** die Stirnseiten (28.1, 30.1) der seitlichen Schenkel (28, 30) von der ersten Seitenfläche (28.2, 30.2) zu der zweiten Seitenfläche jeweils eine Breite aufweisen, die kleiner oder gleich einer maximalen Breite (B1) der Stirnseite (26.1) des Hauptschenkels ist.

7. Gehäuse (10) nach einem der Ansprüche 1 bis 6, **dadurch gekennzeichnet, dass** der Hauptschenkel (26) des Tragrahmens (16) zumindest einen ersten Bereich mit einer maximalen Breite (B1) in eine parallel zu einer Flächennormalen der Verstrebung 22 verlaufenden Richtung gemessen aufweist, wobei die maximale Breite (B1) kleiner 7 mm oder in einem Bereich zwischen 6,3 mm und 6,1 mm oder genau 6,2 mm oder kleiner als 6,2 mm ist.

8. Gehäuse (10) nach Anspruch 7, **dadurch gekennzeichnet, dass** die Stirnseite (26.1) des Hauptschenkels (26) mindestens einen von zwei Stufen (34) begrenzten zweiten Bereich mit einer zweiten Breite (B2) aufweist, wobei die zweite Breite (B2) kleiner als die erste Breite (B1) ist.

9. Gehäuse (10) nach einem der Ansprüche 1 bis 8, **dadurch gekennzeichnet, dass** die Stirnseite (26.1) des Hauptschenkels mindestens eine Durchgangsöffnung oder mindestens eine Aussparung (32) aufweist.

10. Gehäuse (10) nach Anspruch 9, **dadurch gekennzeichnet, dass** die Folie (18) die mindestens eine Durchgangsöffnung oder die mindestens eine Aussparung (32) der Stirnseite (26.1) des Hauptschenkels (26) mit einem ersten Folienabschnitt (48) überdeckt und der erste Folienabschnitt (48) transparent ist.

11. Gehäuse (10) nach einem der Ansprüche 1 bis 10, **dadurch gekennzeichnet, dass** der erste seitlichen Schenkel (28) und/oder der zweite seitliche Schenkel (30) mindestens eine Justiernase (38) aufweist und die Folie (18) ein der mindestens einen Justiernase (38) entsprechendes Durchgangsloch (62) aufweist.

12. Gehäuse (10) nach einem der Ansprüche 1 bis 11, **dadurch gekennzeichnet, dass** der erste seitliche Schenkel (28) und/oder der zweite seitliche Schenkel (30) eine mit der Folie (18) abschließende Fase (36) aufweist.

13. Gehäuse (10) nach einem der Ansprüche 1 bis 12, **dadurch gekennzeichnet, dass** die Folie (18) und der Tragrahmen (16) durch Schweißen oder durch Heißverstemmen kraftschlüssig und / oder stoffschlüssig miteinander verbunden sind.

14. Überspannungsschutzmodul (14), aufweisend eine Platine (12) mit einer Überspannungsschutzeinheit (56),
**dadurch gekennzeichnet, dass**
das Überspannungsschutzmodul (14) ein Gehäuse (10) nach einem der Ansprüche 1 bis 13 aufweist.

15. Überspannungsschutzmodul (14) nach Anspruch 14, **dadurch gekennzeichnet, dass** die Platine (12) mindestens eine Kontaktzunge (50) mit mindestens einer Kontaktfläche (52) aufweist, wobei die Kontaktzunge (50) der Platine (12) über die Verstrebung (22) des Tragrahmens (16) oder über den ersten seitlichen Schenkel (28) und/oder den zweiten seitlichen Schenkel (30) hinausragt.

## Claims

1. Housing (10) for receiving a circuitboard (12) with an overvoltage protection unit (56), comprising a support frame (16), wherein
- the support frame (16) consists at least partly of a thermoplastic plastics material and has a main limb (26), two lateral limbs (28, 30), which are each connected at a respective end with the main limb (26), and at least one flat brace (22) laterally extending between the two lateral limbs (28, 30),
**characterised in that**
a foil is provided and
- the foil (18) consists at least partly of a thermoplastic plastics material and is formed to be U-shaped with an end face (18.1) and two side surfaces (18.2, 18.3),
- the end face (18.1) of the foil (18) at least partly covers an end face (26.1) of the main limb (26),
- each side surface (182, 18.3) of the foil (18) at least partly covers a respective one of the two lateral limbs (28, 30) as well as the strut (22) and
- the foil (18) is connected with the lateral limbs (28, 30) by material couple,
- so that the housing (10) consisting of support frame (16) and foil (18) is at least partly open at a side opposite the end face (18.1) of the foil (18).

2. Housing (10) according to claim 1, **characterised in that** the brace (22) is formed as a surface with at least one passage opening (24) or as a web.

3. Housing (10) according to claim 1 or claim 2, **characterised in that** the support frame (16) consists of a different material from the foil (18).

4. Housing (10) according to any one of claims 1 to 3, **characterised in that** the support frame (16) in a prolongation of the main limb (26) has an additional receptacle (40), which is connected with the second lateral limb (30) or with the first lateral limb (28), for a digital connecting member having at least four contacts.

5. Housing (10) according to any one of claims 1 to 4, **characterised in that** the two lateral limbs (28, 30) each have an end face (28.1, 30.1), a first side surface (28.2, 30.2) adjoining the end face (28.1, 30.1) and a second side surface adjoining the end face (28.1, 30.1) and opposite the first side surface (28.2, 30.2).

6. Housing (10) according to claim 5, **characterised in that** the end faces (28.1, 30.1) of the lateral limbs (28, 30) each have from the first side surface (28.2, 30.2) to the second side surface a width which is smaller than or equal to a maximum width (B1) of the end face (26.1) of the main limb.

7. Housing (10) according to any one of claims 1 to 6, **characterised in that** the main limb (26) of the support frame (16) has at least one first region with a maximum width (B1) measured in a direction extending parallel to a surface normal of the strut (22), wherein the maximum width (B1) is smaller than 7 millimetres or is in a range between 6.3 millimetres and 6.1 millimetres or is exactly 6.2 millimetres or less than 6.2 millimetres.

8. Housing (10) according to claim 7, **characterised in that** the end face (26.1) of the main limb (26) has at least one second region, which is bounded by two steps (34), with a second width (B2), wherein the second width (B2) is smaller than the first width (B1).

9. Housing (10) according to any one of claims 1 to 8, **characterised in that** the end face (26.1) of the main limb has at least one passage opening or at least one recess (32).

10. Housing (10) according to claim 9, **characterised in that** the foil (18) covers the at least one passage opening or the at least one recess (32) of the end face (26.1) of the main limb (26) by a first foil section (48) and the first foil section (48) is transparent.

11. Housing (10) according to any one of claims 1 to 10, **characterised in that** the first lateral limb (28) and/or the second lateral limb (30) has or have at least one adjustment dog (38) and the foil (18) has at least one passage opening (62) corresponding with the at least one adjustment dog (38).

12. Housing (10) according to any one of claims 1 to 11, **characterised in that** the first lateral limb (28) and/or the second lateral limb (30) has or have a chamfer (36) flush with the foil (18).

13. Housing (10) according to any one of claims 1 to 12, **characterised in that** the foil (18) and the support frame (16) are connected together frictionally and/or by material couple through welding or through heat staking.

14. Overvoltage protection module (14) comprising a circuitboard (12) with an overvoltage protection unit (56), **characterised in that** the overvoltage protection module (14) comprises a housing (10) according to any one of claims 1 to 13.

15. Overvoltage protection module (14) according to claim 14, **characterised in that** the circuitboard (12) has at least one contact tongue (50) with at least one contact surface (52), wherein the contact tongue (50) of the circuitboard (12) projects beyond the brace (22) of the support frame (16) or beyond the first lateral limb (28) and/or the second lateral limb (30).

## Revendications

1. Boîtier (10) de réception d'une platine (12) comprenant une unité de protection contre les surtensions (56), présentant un cadre de support (16), dans lequel
- le cadre de support (16) est composé au moins en partie d'une matière plastique thermoplastique et présente une branche principale (26), deux branches latérales (28, 30) se raccordant respectivement par une extrémité à la branche principale (26) et au moins un entretoisement latéral plat (22) s'étendant entre les deux branches latérales (28, 30),
**caractérisé en ce que**
- il est prévu une feuille, et
- la feuille (18) se compose au moins en partie d'une matière plastique thermoplastique et est configurée en forme de U avec une face frontale (18.1) et deux faces latérales (18.2, 18.3),
- la face frontale (18.1) de la feuille (18) recouvre au moins en partie une face frontale (26.1) de la branche principale (26),
- chaque face latérale (18.2, 18.3) de la feuille (18) recouvre au moins en partie respectivement les deux branches latérales (28, 30) ainsi que l'entretoisement (22) et
- la feuille (18) est assemblée matériellement aux branches latérales (28, 30),
- de telle manière que le boîtier (10) composé du cadre de support (16) et de la feuille (18) soit ouvert au moins en partie sur une face opposée à la face frontale (18.1) de la feuille (18).

2. Boîtier (10) selon la revendication 1, **caractérisé en ce que** l'entretoisement (22) est réalisé sous la forme d'une face avec au moins une ouverture de passage (24) ou sous la forme d'une âme.

3. Boîtier (10) selon la revendication 1 ou la revendication 2, **caractérisé en ce que** le cadre de support (16) se compose d'un autre matériau que la feuille (18).

4. Boîtier (10) selon l'une quelconque des revendications 1 à 3, **caractérisé en ce que** le cadre de support (16) présente dans un prolongement de la branche principale (26) un logement additionnel (40) se raccordant à la deuxième branche latérale (30) ou à la première branche latérale (28) pour une pièce de connexion digitale présentant au moins quatre contacts.

5. Boîtier (10) selon l'une quelconque des revendications 1 à 4, **caractérisé en ce que** les deux branches latérales (28, 30) présentent respectivement une face frontale (28.1, 30.1), une première face latérale (28.2, 30.2) adjacente à la face frontale (28.1, 30.1) et une deuxième face latérale adjacente à la face frontale (28.1, 30.1) et opposée à la première face latérale (28.2, 30.2).

6. Boîtier (10) selon la revendication 5, **caractérisé en ce que** les faces frontales (28.1, 30.1) des branches latérales (28, 30) présentent, de la première face latérale (28.2, 30.2) à la deuxième face latérale respectivement une largeur, qui est inférieure ou égale à une largeur maximale (B1) de la face frontale (26.1) de la branche principale.

7. Boîtier (10) selon l'une quelconque des revendications 1 à 6, **caractérisé en ce que** la branche principale (26) du cadre de support (16) comporte au moins une première région présentant une largeur maximale (B1) mesurée dans une direction s'étendant parallèlement à une normale à la surface de l'entretoisement (22), dans lequel la largeur maximale (B1) est inférieure à 7 mm ou se situe dans une plage comprise entre 6,3 mm et 6,1 mm ou vaut exactement 6,2 mm ou est inférieure à 6,2 mm.

8. Boîtier (10) selon la revendication 7, **caractérisé en ce que** la face frontale (26.1) de la branche principale (26) comporte au moins une deuxième région limitée par deux seuils (34) et présentant une deuxième largeur (B2), dans lequel la deuxième largeur (B2) est inférieure à la première largeur (B1).

9. Boîtier (10) selon l'une quelconque des revendications 1 à 8, **caractérisé en ce que** la face frontale (26.1) de la branche principale présente au moins une ouverture de passage ou au moins une découpe (32).

10. Boîtier (10) selon la revendication 9, **caractérisé en ce que** la feuille (18) recouvre ladite au moins une ouverture de passage ou ladite au moins une découpe (32) de la face frontale (26.1) de la branche principale (26) avec une première partie de feuille (48) et la première partie de feuille (48) est transparente.

11. Boîtier (10) selon l'une quelconque des revendications 1 à 10, **caractérisé en ce que** la première branche latérale (28) et/ou la deuxième branche latérale (30) présente(nt) au moins une broche d'ajustage (38) et la feuille (18) présente un trou de passage (62) correspondant à ladite au moins une broche d'ajustage (38).

12. Boîtier (10) selon l'une quelconque des revendications 1 à 11, **caractérisé en ce que** la première branche latérale (28) et/ou la deuxième branche latérale (30) présente(nt) un chanfrein (36) se fermant avec la feuille (18).

13. Boîtier (10) selon l'une quelconque des revendications 1 à 12, **caractérisé en ce que** la feuille (18) et le cadre de support (16) sont assemblés l'un à l'autre par une liaison dynamique et/ou matérielle par soudage ou matage à chaud.

14. Module de protection contre les surtensions (14), présentant une platine (12) comprenant une unité de protection contre les surtensions (56), **caractérisé en ce que** le module de protection contre les surtensions (14) présente un boîtier (10) selon l'une quelconque des revendications 1 à 13.

15. Module de protection contre les surtensions (14) selon la revendication 14, **caractérisé en ce que** la platine (12) présente au moins une lamelle de contact (50) avec au moins une face de contact (52), dans lequel la lamelle de contact (50) de la platine (12) s'étend au-delà de l'entretoisement (22) du cadre de support (16) ou au-delà de la première branche latérale (28) et/ou au-delà de la deuxième branche latérale (30).
